# EUROPEAN PATENT APPLICATION

(11) **EP 0 675 157 A1**
(43) Date of publication of application: **04.10.1995**
(21) Application number: 95104251.4
(22) Date of filing: 23.03.1995
(51) Int. Cl.: C08J 7/04, C08J 7/06, C09D 133/12, C23C 14/20

(54) **Primer for adhering conductive films to acrylic or polycarbonate substrates**

(30) Priority: 29.03.1994 US 219334
(71) Applicant: PPG INDUSTRIES, INC., Pittsburgh Pennsylvania 15272 (US)
(72) Inventor: Rukavina, Thomas G., Lower Burrell, Pennsylvania 15068 (US); Slobodnik, John B., New Kensington, Pennsylvania (US)
(74) Representative: Sternagel, Hans-Günther, Dr.

(57) **Abstract**

The purpose of the present invention is to provide novel primer compositions for use in bonding an electroconductive film, particularly an electroconductive metal oxide film, to the surface of a polymeric substrate. The novel primer compositions of the invention comprise copolymers of acrylic acid and substituted acrylate monomers such as methyl methacrylate. The construction of the article of the present invention preferably comprises a transparent polymeric substrate, such as acrylic or polycarbonate, on a surface thereof a primer composition of a copolymer of acrylic acid and a substituted acrylate monomer such as methylmethacrylate and deposited on the primer an electroconductive film, such as tin oxide. The effect of the primer composition of the present invention is to provide adequate adhesion of the electroconductive film to the polymeric substrate, as well as to prevent crazing and/or cracking of the electroconductive film or the polymeric substrate. The resulting article is particularly useful as a transparency in aircraft.

## Description

### BACKGROUND OF THE INVENTION

This invention relates generally to the art of laminated transparencies, and more particularly to the art of plastic transparencies comprising plastic substrates, most particularly to the art of bonding electroconductive metal oxide films to plastic substrates.

U.S. Patent Nos. 4,554,319; 4,609,703 and 4,670,350 to Rukavina disclose novel copolymers of acrylic acid and cyanoethylacrylate, including terpolymers with hydroxyethylacrylate, useful as primers for bonding metal-containing coatings to organic polymer substrates.

### SUMMARY OF THE INVENTION

The present invention comprises novel primer compositions to bond an electroconductive film to a surface of a polymeric substrate. The present invention provides primers comprising copolymers of acrylic acid and substituted acrylates such as methyl methacrylate, which promote adhesion of electroconductive metal oxide films on polymer substrates, such as acrylic and polycarbonate, for use as transparencies, particularly in aircraft.

### DESCRIPTION OF PREFERRED EMBODIMENTS

The polymeric substrate primed with the compositions of the present invention is preferably a transparent material suitable for forming laminates which may be used as transparencies in aircraft. Polycarbonate and polyacrylate substrates may be used. A preferred polymer substrate for aircraft transparencies is stretched acrylic.

The electroconductive film is preferably a transparent thin film of metal or metal oxide, preferably fluorine-doped tin oxide or tin-doped indium oxide and tin oxide, commonly referred to as ITO (indium/tin oxide), preferably comprising a weight ratio of about 90:10 indium and tin. The film thickness is preferably in the range of 2000 to 4000 Angstroms for acceptable conductivity. The electroconductive film may be deposited by a variety of methods so long as the polymeric substrate is not deleteriously affected. High temperature pyrolytic methods typically used to deposit electroconductive films on glass are not suitable for plastic substrates. A preferred method of depositing ITO on plastic is direct current sputtering, particularly magnetron sputtering (MSVD). However, the adhesion of MSVD electroconductive metal oxide films to plastic substrates is not generally adequate for electrochromic devices of the present invention.

The primer of the present invention is disposed at the interface of the plastic substrate and electroconductive film to provide adequate adhesion of the electroconductive film to the plastic substrate, as well as to prevent crazing and/or cracking of the plastic or the electroconductive film. The primer of the present invention is an acrylate copolymer, preferably a copolymer of acrylic acid and methyl methacrylate. Preferably, the molar ratio of acrylic acid to methyl methacrylate is from about 3 to 1 to 1 to 3. The primer composition preferably comprises a free radical initiator such as azobis(isobutylonitrile). The primer is preferably applied to the substrate surface as a solution in organic solvent by dip, spin, spray, flow or other conventional application technique. The organic solvent is then evaporated and the primer cured at slightly elevated temperature. The solvent may be 1-butanol, cyclohexanone, acetone, mixtures of such solvents, and is preferably 1-butanol and/or 1-propanol. The solution preferably includes a curing catalyst, such as dibutyltindilaurate (DBTDL) or uranyl nitrate. A preferred method of applying the primer is flow coating onto a plastic substrate surface, drying and curing at elevated temperature, typically about 180°F (about 82°C). The thickness of the primer is preferably in the range of about 0.01 to 0.50 microns, more preferably about 0.29 to 0.46 microns for optimum adhesion. The linear polymer is preferably crosslinked with cycloaliphatic diepoxides such as 2-[3,4-epoxy cyclohexyl-5,5-spiro-3,4-epoxy] cyclohexanemetadioxane; bis[3,4-epoxycyclohexyl] adipate; and 3,4-epoxycyclohexyl-3,4-epoxy-cyclohexane-carboxylate.

The primer of the present invention promotes adhesion of electroconductive films on acrylic and polycarbonate substrates, and also resists swelling of the polymer and subsequent cracking of the electroconductive films under high humidity conditions.

The present invention will be further understood from the descriptions of specific examples which follow:

### EXAMPLE I

A copolymer of 1 mole of methyl methacrylate and 3 moles of acrylic acid was prepared in 1-butanol at 25 percent by weight monomer concentration. Azobisisobutyronitrile was used as the initiator at a concentration of 0.05 percent by weight of solution. The reaction was sparged with nitrogen for 15 minutes and the reaction mixture heated to 90°C for 24 hours under inert atmosphere. The solution was then diluted to 10 percent solids using the same solvent. To this solution was added a stoichiometric amount of 2-[3,4-epoxy cyclohexyl-5,5-spiro-3,4-epoxy] cyclohexane-metadioxane to react all of the carboxylic acid groups. A surfactant (FC-430 from 3M) was added at 0.05 percent by weight of the solution along with 0.1 percent by weight of dibutyltin dilaurate catalyst for the cycloaliphatic epoxy/carboxylic acid reaction. The solution was diluted to 10 percent solids with 50/50 cyclohexanone/acetone. The solution was applied to a polymer substrate and cured for 8 hours at 180°F (82°C). An electroconductive coating of indium/tin oxide (ITO) was then deposited onto the primed polymer surface by direct current (dc) magnetron sputtering at a temperature of 140°F (60°C) to an ITO film thickness of about 2600 Angtroms.

The above example is offered to illustrate the present invention without limiting its scope, which is defined by the following claims. Various other materials and process conditions may be used. For example, while the examples utilize ITO as an electroconductive film, other materials such as fluorine-doped tin oxide, antimony-doped tin oxide and aluminum-doped zinc oxide could be used, preferably with sheet resistances in the range of 10 to 20 ohms per square. Other polymer substrates may also be used in the transparencies of the present invention, the scope of which is defined by the following claims.

## Claims

1. An article of manufacture comprising:
a. a transparent polymeric substrate;
b. disposed on a surface of said substrate a primer layer comprising a copolymer of acrylic acid and methyl methacrylate; and
c. an electroconductive metal oxide film deposited on said primer layer.

2. An article according to claim 1, wherein said polymeric substrate is selected from the group consisting of polycarbonates and acrylics.

3. An article according to claim 2, wherein said primer is a copolymer of acrylic acid and methyl methacrylate in a molar ratio of from about 3:1 to about 1:3.

4. An article according to claim 1, wherein said electroconductive metal oxide film is selected from the group consisting of tin oxide and indium/tin oxide.

5. An article according to claim 4, wherein said electroconductive metal oxide film is indium/tin oxide.

6. An article of manufacture comprising:
a. a transparent substrate selected from the group consisting of polycarbonate and acrylic;
b. disposed on a surface of said substrate a primer layer of a copolymer of acrylic acid and methyl methacrylate; and
c. an electroconductive metal oxide film.

7. An article according to claim 6, wherein said electroconductive film is indium/tin oxide.
